# EUROPEAN PATENT SPECIFICATION

(11) **EP 0 453 070 B1**
(45) Date of publication and mention of the grant of the patent: **11.06.1997**
(21) Application number: 91301443.7
(22) Date of filing: 22.02.1991
(51) Int. Cl.: H01L 27/088, H01L 21/82, H01L 27/06

(54) **Method of manufacturing an intelligent power semiconductor device**
Verfahren zur Herstellung eines intelligenten Leistungshalbleiterbauelements
Méthode de fabrication d'un dispositif semi-conducteur de puissance intelligent

(30) Priority: 23.02.1990 JP 42859/90
(43) Date of publication of application: 23.10.1991
(73) Proprietor: Nippon Motorola Ltd., Minato-Ku Tokio 106 (JP)
(72) Inventor: Ishiguro, Takeshi, Aizuwakamatsu-shi, Fukushima-ken (JP)
(74) Representative: Lupton, Frederick

(56) References cited:
- EP-A- 0 193 172
- EP-A- 0 282 734
- EP-A- 0 314 465
- PATENT ABSTRACTS OF JAPAN vol. 11, no. 27 (E-474)(2474) 27 January 1987 & JP-A-61 196 568
- NEC RESEARCH AND DEVELOPMENT. no. 90, July 1988, TOKYO JP pages 1 - 9; M.HATTORI ET AL.: 'MOS Power Driver ICs for DC Motors'

## Description

### Field of the Invention

The present invention relates, in general, to a method of manufacturing an intelligent power semiconductor device. More particularly, the invention relates to a method of manufacturing a semiconductor device having a power transistor and a small signal transistor formed together on a common semiconductor substrate, by which a threshold voltage of each of the transistors is suitably set without causing to develop a dispersion thereof and a thickness for each gate insulation film for the power transistor and the small signal transistor can be individually controlled.

### Background of the Invention

Recently, an intelligent power semiconductor device having a power transistor and a small signal transistor for a logic circuit and the like formed together on a common substrate is practically used. In this type of the intelligent power semiconductor device, each of the power transistor and the small signal transistor is required to have a certain quality, performance and the like most suitable for operations of each transistor. For example, a threshold voltage of the small signal transistor must have the value most suitable to constitute the logic circuit and the value must be less dispersed among finished devices.

Assuming that the small signal transistor is composed of a CMOS and the power transistor is composed of an LDMOS (Laterally Diffused MOS), for example, the intelligent power semiconductor device has been conventionally manufactured, see for example European Patent Application no. EP-A-0314465 and Patent Abstracts of Japan, vol. 11, no. 27 (E-474)[2474], January 1987 & Japanese Application no. JP-A-61196568, by the following steps:
(1) an N type epitaxial layer is formed on a P type semiconductor substrate;
(2) a P type well is formed to constitute a CMOS logic circuit;
(3) gate oxide films are formed for both power transistor and small signal transistor;
(4) impurities are implanted into each channel of the CMOS transistors to adjust the threshold voltage thereof;
(5) a gate of polysilicon is formed on each of the gate oxide films by photo-etching technique;
(6) a P type tab region or a PHV region is formed by, diffusion process to form the channel region of the power transistor;
(7) a source region and a drain region are formed for each transistor; and
(8) an interlayer insulation film is deposited, and a metal wiring is formed, and then a passivation treatment or the like follows.

However, in such a prior manufacturing method, a drawback arises in that since diffusion is carried out at high temperature to form the PHV region of the power transistor after completion of the aforesaid process (4) for implanting the impurities to adjust the threshold voltage of the CMOS type small signal transistor, the threshold voltage of the small signal transistor, in particular, the threshold voltage of the P channel transistor which was adjusted previously by implanting boron or the like, is varied by influence of the subsequent processes.

To overcome this kind of drawback, it can be considered that, for example, after the gate oxide film has been formed in the aforementioned process, the PHV region for the power transistor is formed, and thereafter a channel implantation is further carried out to adjust the threshold voltage of MOS transistor.

However, in this solution, it is required that after the gate electrodes of the polysilicon or the like have been formed, ions are implanted through the gate electrodes to adjust the threshold voltage. Thus, in this method, a drawback arises in that, when the thickness of the polysilicon layers constituting the gate electrodes are dispersed, a depth of distribution of the impurities implanted into the channels is varied with the result of the dispersion of the threshold voltage.

Further, in these methods, since the gate insulation films of the power transistor and the small signal transistor are simultaneously formed, a drawback also arises in that the gate insulation film cannot be adjusted to have the most suitable thickness in accordance with the characteristics of each of the transistors.

### Summary of the Invention

Accordingly, it is an object of the present invention to provide an improved method for manufacturing an intelligent power semiconductor device having a power transistor and a small single transistor formed together on a common substrate, by which the threshold voltage of each transistor is free from variations caused by influences of subsequent processes and further the threshold voltage is restricted from being dispersed.

It is a further object of the present invention to provide an improved method for manufacturing the intelligent power semiconductor device, by which the gate insulation film having a thickness most suitable for each of the power transistor and the small signal transistor can be individually formed.

In accordance with the present invention there is provided a method of manufacturing an intelligent power semiconductor device having a power transistor and a small signal transistor formed together on a common semiconductor substrate, comprising the sequential steps :
forming a second conductive type epitaxial layer on a first conductive type semiconductor substrate;
forming a first conductive type isolation region in said epitaxial layer to isolate the region where said power transistor is formed from the region where said small signal transistor is formed thereon;
forming a first conductive type well region for said small signal transistor;
forming a gate insulation film for said power transistor;
forming a conductive layer for a gate electrode of said power transistor on said gate insulation film;
forming a first conductive type tab region for said power transistor;
forming a gate insulation film for said small signal transistor;
introducing impurities into the channel region of said small signal transistor to adjust the threshold voltage thereof;
forming a conductive layer for a gate electrode of said small signal transistor; and
forming a source electrode and a drain electrode for each of said transistors.

In the aforesaid manufacturing method, since the process of forming the tab region of the power transistor is followed by the process of introducing impurities into the channel region of the small signal transistor to adjust the threshold voltage thereof, the threshold voltage of the small signal transistor is not influenced by the process of forming the tab region of the power transistor. Further, since the process of introducing the impurities into the channel region of the small signal transistor to adjust the threshold voltage thereof is followed by the process of forming the conductive layer for gate electrode for the small signal transistor, the channel implantation needs not be carried out through the conductive layer for gate electrode to adjust the threshold voltage, and thus the threshold voltage is not dispersed caused by a difference of the thickness of the conductive layer for gate electrode or the like. Since the process of forming the gate insulation film of the power transistor and the process of forming the gate insulation film of the small signal transistor are independently carried out, the gate insulation films each having the thickness most suitable for the power transistor and the small signal transistor can be provided.

When the small signal transistor is composed of a CMOS, a second conductive type epitaxial layer is preformed on a first conductive type semiconductor substrate and then the first conductive type isolation region is formed on the epitaxial layer, as described above, so that the region where the power transistor is formed can be properly isolated from the region where the small signal transistor is formed. Then the preformation of the first conductive type well region in an isolated region for forming the small signal transistor permits a logic circuit and the like composed of a CMOS to be suitably formed on the same semiconductor substrate on which the power transistor is formed .

### Brief Description of the Drawings

FIGS. 1 through 12 show, respectively, a cross-sectional elevation view to explain the respective processes for manufacturing an intelligent power semiconductor device according to an embodiment of the present invention; and
FIGS. 13(a) and 13(b) are graphs illustrating, respectively, a relationship between the threshold voltage and a dosed amount for both P channel and N channel transistors of the intelligent power semiconductor device manufactured in accordance with the present invention.

### Detailed Description of the Invention

To facilitate understanding the present invention, an embodiment is described below with reference to drawings.

It will, however, be obvious to one skilled in the art that the present invention may be practiced without specific details. In other instances, well-known processing steps and structures have not been described in detail in order not to obscure the present invention in unnecessary detail.

The intelligent power semiconductor device manufactured under the present invention has a CMOS arrangement in the portion thereof for a small signal circuit and a LDMOS arrangement in the portion thereof for a power transistor circuit

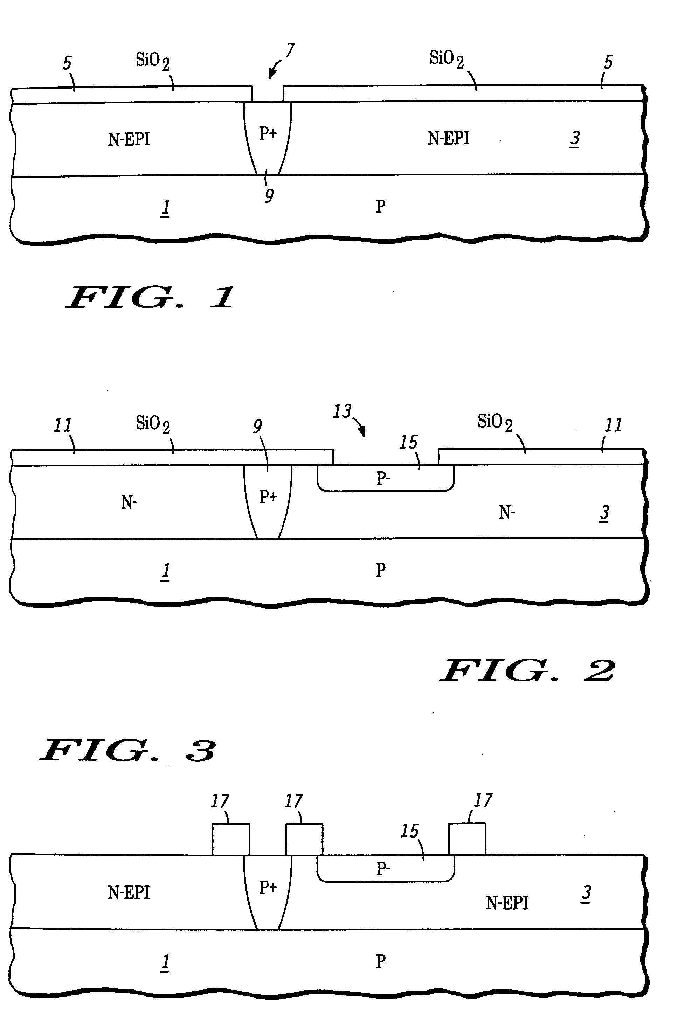

As shown in a cross-sectional view in Fig.1, an N⁻ type epitaxial region 3 is first formed on a P type semiconductor substrate 1 by a well known epitaxial growth technique. Then, a mask layer 5 of silicon dioxide (SiO₂) is formed on the epitaxial region 3 and a portion 7 of the mask layer 5 corresponding to an isolation region is removed by etching. Next, for example, boron tribromide BBr₃ is diffused from the epitaxial layer 3 to the substrate 1 using the mask layer 5 to form a P⁺ type isolation region 9. The isolation region 9 is used to isolate the region where a small signal transistor is formed from the region where a power transistor is formed.

Next, as shown in Fig. 2, a mask layer 11 of silicon dioxide or the like having an opening corresponding to a small signal circuit region is formed and boron (B) is doped through the opening 13 of the mask 11 by diffusion or the like to form a P⁻ type well 15.

Next, as shown in Fig.3, a thick field isolation oxide film 17 is formed to isolate the respective transistors and the like. The field oxide film 17 is formed of, for example, silicon dioxide.

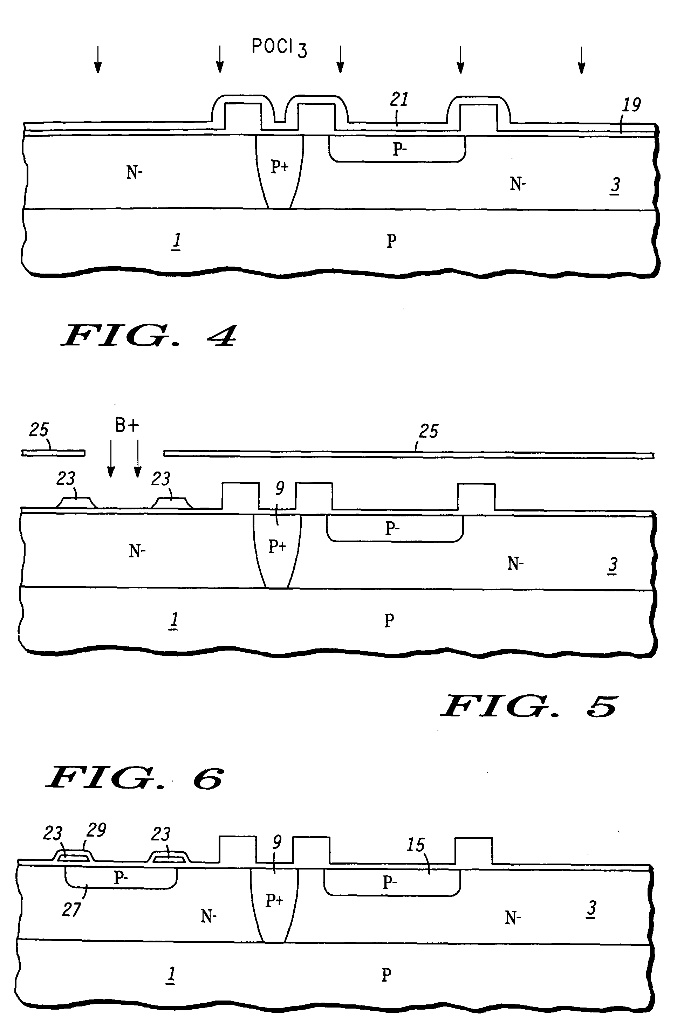

Next, as shown in Fig. 4, a gate oxide film 19 serving as the gate insulation film of the power transistor is formed over the substrate to a desired thickness and then a polysilicon layer 21 for a gate electrode is deposited. Then, phosphorous oxychloride (POCl₃) is doped to lower the resistance of the polysilicon layer 21.

Next, as shown in Fig. 5, the polysilicon layer 21 is etched to form the gate electrode 23 of the power transistor. Further, boron ( B⁺ ) is implanted through a resist layer 25 having an opening corresponding to the tab region of the power transistor. Note that, the two gate electrodes 23 for the power transistor are shown in Fig. 5, but these are actually connected together, because the gate electrode for the power transistor according to the present embodiment has, for example, a ring shape.

Next , as shown in Fig. 6, the boron implanted as described above is diffused to form a P⁻ type tab region or a PHV region 27. Note that since there is a possibility that nitride may be produced by a reaction of the silicon of the gate electrode 23 and the like with nitrogen in an atmosphere in which the diffusion is carried out, oxygen is actually added to the atmosphere. As a result, an oxide film 29 of silicon dioxide ( SiO₂ ) is formed on the gate electrode 23 and the like.

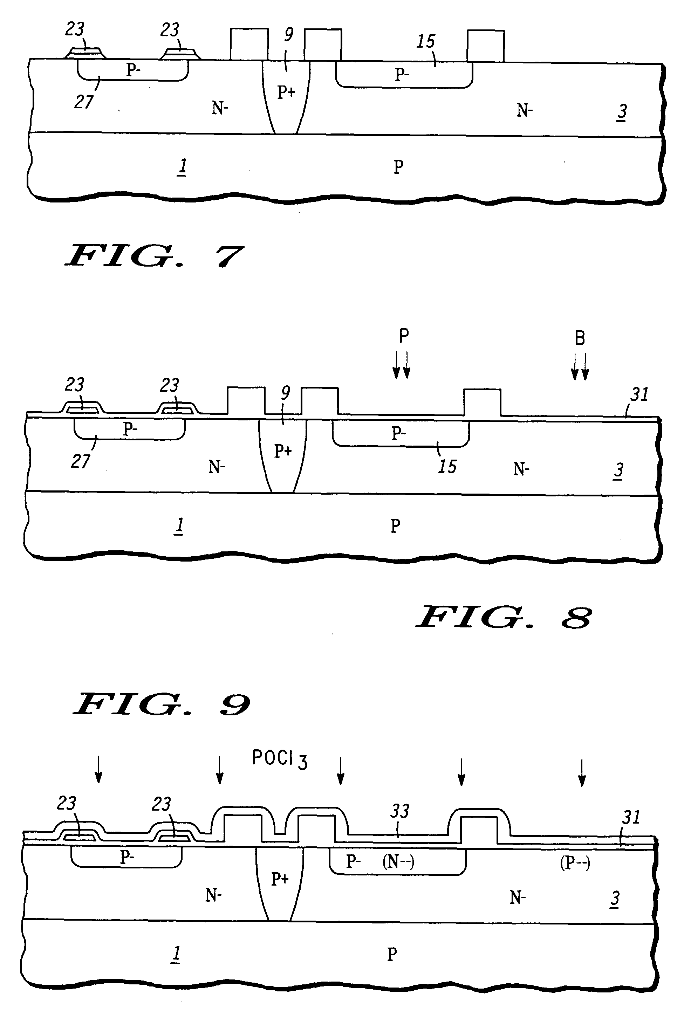

Then, as shown in Fig. 7, the oxide film formed on the surface of the substrate is removed.

Next, as shown in Fig. 8, the surface of the substrate is oxidized to a desired thickness to form a gate oxide film 31 serving as the gate insulation film of the small signal transistor. Then, impurities are implanted into a channel portion of each transistor to adjust the threshold voltage of the small signal transistor. More particularly , for example, phosphorus (P) is implanted into the channel portion of the N⁻ channel transistor formed on the P⁻ type well 15 and boron (B) is implanted into the channel region of the P channel transistor formed on the N⁻ type epitaxial layer 3 to adjust the threshold value thereof.

Next, as shown in Fig. 9, a polysilicon layer 33 is deposited on the oxide film 31 to form the gate electrode of the small signal transistor, and , for example, phosphorus oxychloride as N⁺ type impurities is doped to lower the resistance of the polysilicon layer 33.

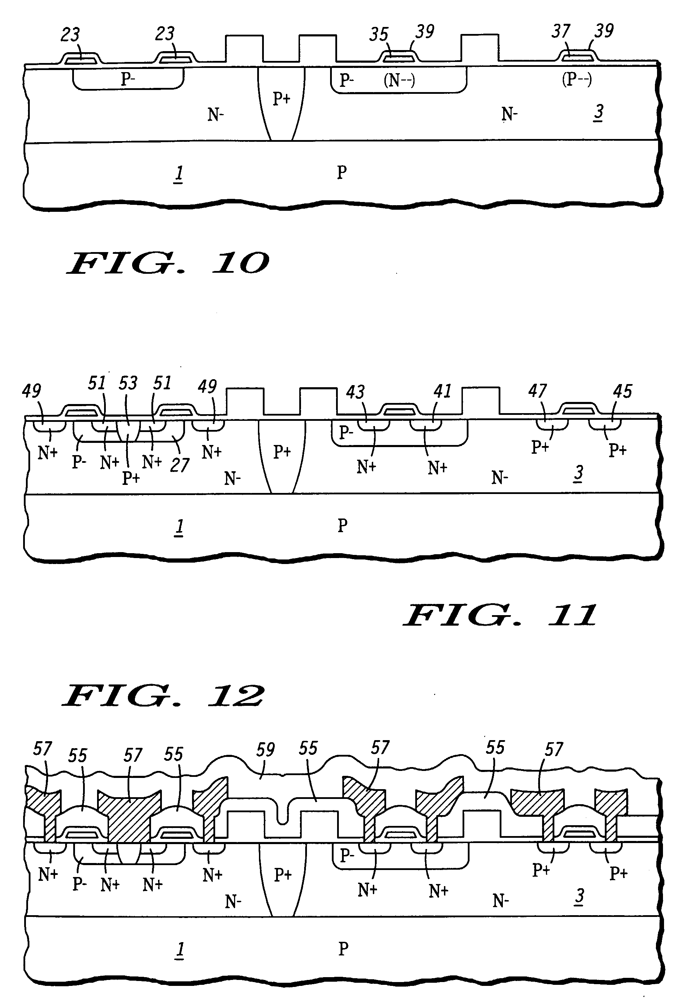

Further, as shown in Fig. 10, the doped polysilicon layer 33 is patterned to form the gate electrodes 35 and 37 of the small signal transistor. Then, the surface of the polysilicon layer is oxidized to form oxide film 39 so that the thus formed gate electrode 35,37 and the like are protected.

Next, as shown in Fig. 11, ion implantation is carried out into respective portions to form source and drain electrodes. More specifically, in the small signal circuit region, an N⁺ type drain region 41 and N⁺ type source region 43 are formed in the P⁻ well 15, and a P⁺ type drain region 45 and a P⁺ type source region 47 are formed in the portion of N⁻ type epitaxial layer 3 at both sides of the gate electrode 37 to form the P⁻ channel transistor. And then, an N⁺ diffused region 49 constituting the drain electrode is formed to a ring-shape in the power circuit region and an N⁺ type source region 51 is formed inside the ring-shaped portion of the gate electrode 23. Further, a P⁺ type region 53 is formed at the center of the N⁺ type source region 51. This P⁺ type region 53 is used to connected the P⁻ type tab 27 to the source region 51 later.

The main portions for the power transistor and the small signal transistor are now fabricated as described above. Following after the aforesaid steps, as show in Fig. 12, an interlayer insulation film is deposited over the substrate and the contact hole portions are etched thereof. Then, a wiring layer of aluminum or the like is formed on the surface thereof is covered by silicon dioxide or the like for passivation.

Note that the respective figures cited for the above description are used only for an illustrative purpose and thus the size , configuration and ratio of size for each portion shown in the figures may be different from those of the actual device.

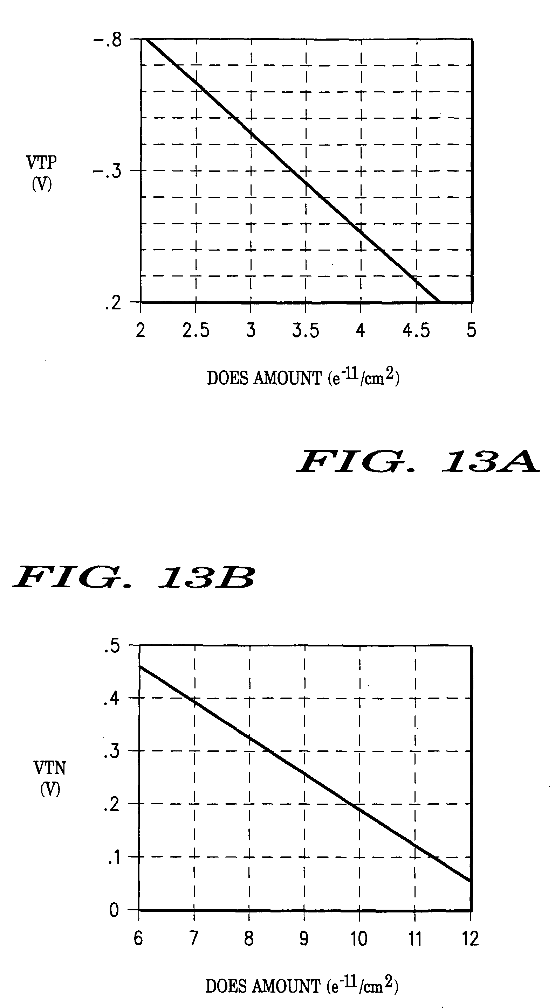

Fig. 13 (a) and Fig. (b) show a relationship between the threshold voltage and the dosed amount of impurities in the intelligent power semiconductor device fabricated by the method according to the embodiment of the present invention.

FIG. 13 (a) is a graph illustrating a relationship between the threshold voltage VTP and the dosed amount for the P channel MOS transistor, and Fig. 13 (b) shows a relationship between the threshold voltage VTN and the dosed amount for the N channel MOS transistor. As shown in these graphs, the respective threshold voltages VTP and VTN of the semiconductor devices fabricated in accordance with the present invention are substantially proportional to the dosed amount in the channel portion with little dispersion caused by other factors such as the influence of the other processes, thickness of polysilicon layer for the gate electrode and the like.

As described above, according to the present invention, even if the power transistor and small signal transistor are integrated on the same semiconductor substrate, the characteristics such as the threshold voltage of the transistors are not adversely affected by the respective processes and can be properly controlled by ion implantation into channel . Further, since the threshold voltage is not affected by the thickness of the gate conductive layer and the like, the threshold voltage is little dispersed among wafers and thus the threshold voltage and the like can be highly precisely controlled. In addition to the above, since the thickness of the gate oxide films can be individually controlled to a value suitable for the power transistor and the small signal transistor, respectively, an intelligent power semiconductor device of a high performance can be fabricated in a practical manner.

## Claims

1. A method of manufacturing an intelligent power semiconductor device having a power transistor and a small signal transistor formed together on a common semiconductor substrate, comprising the sequential steps:
forming a second conductive type epitaxial layer (3) on a first conductive type semiconductor substrate (1);
forming a first conductive type isolation region (9) in said epitaxial layer to isolate the region where said power transistor is formed from the region where said small signal transistor is formed thereon;
forming a first conductive type well region (15) for said small signal transistor;
forming a gate insulation film (19) for said power transistor;
forming a conductive layer (21) for a gate electrode (23) of said power transistor on said gate insulation film;
forming a first conductive type tab region (27) for said power transistor;
forming a gate insulation film (31) for said small signal transistor;
introducing impurities into the channel region of said small signal transistor to adjust the threshold voltage thereof;
forming a conductive layer (33) for a gate electrode (35, 37) of said small signal transistor; and
forming a source electrode (57) and a drain electrode (57) for each of said transistors.

## Patentansprüche

1. Verfahren zur Herstellung eines intelligenten Leistungshalbleiterbauelements mit einem auf einem gemeinsamen Halbleitersubstrat zusammen gebildeten Leistungstransistor und einem Kleinsignaltransistor, das die aufeinanderfolgenden Schritte umfaßt:
Bilden einer Epitaxialschicht (3) eines zweiten Leitfähigkeitstyps auf einem Substrat (1) eines ersten Leitfähigkeitstyps;
Bilden eines Isolierbereiches (9) des ersten Leitfähigkeitstyps in der Epitaxialschicht, um den Bereich, wo der Leistungstransistor gebildet wird, von dem Bereich zu isolieren, wo der Kleinsignaltransistor darauf gebildet wird;
Bilden eines Wannenbereiches (15) des ersten Leitfähigkeitstyps für den Kleinsignaltransistor;
Bilden eines Gateisolierfilms (19) für den Leistungstransistor;
Bilden einer leitfähigen Schicht (21) für eine Gateelektrode (23) des Leistungstransistors auf dem Gateisolierfilm;
Bilden eines Laschenbereiches (27) des ersten Leitfähigkeitstyps für den Leistungstransistor;
Bilden eines Gateisolierfilms (31) für den Kleinsignaltransistor;
Einführen von Fremdatomen in den Kanalbereich des Kleinsignaltransistors, um dessen Schwellenspannung einzustellen;
Bilden einer leitfähigen Schicht (33) für eine Gateelektrode (35, 37) des Kleinsignaltransistors und
Bilden einer Sourceelektrode (57) und einer Drainelektrode (57) für jeden der Transistoren.

## Revendications

1. Procédé de fabrication d'un dispositif semi-conducteur de puissance intelligent ayant un transistor de puissance et un transistor de petit signal formés ensemble sur un substrat semi-conducteur commun, comprenant les étapes séquentielles de :
formation d'une couche épitaxiale du second type de conductivité (3) sur un substrat semi-conducteur d'un premier type de conductivité (1) ;
formation d'une zone isolante du premier type de conductivité (9) dans ladite couche épitaxiale pour isoler la zone où ledit transistor de puissance est formé à partir de la zone où ledit transistor de petit signal est formé sur celle-ci ;
formation d'une zone de caisson du premier type de conductivité (15) pour ledit transistor de petit signal ;
formation d'une couche isolante de grille (19) pour ledit transistor de puissance ;
formation d'une couche conductrice (21) pour une électrode de grille (23) dudit transistor de puissance sur ladite couche isolante de grille ;
formation d'une zone plate du premier type de conductivité (27) pour ledit transistor de puissance ;
formation d'une couche isolante de grille (31) pour ledit transistor de petit signal ;
introduction d'impuretés dans la zone de canal dudit transistor de petit signal pour régler la tension de seuil de celui-ci ;
formation d'une couche conductrice (33) pour l'électrode de grille (35, 37) dudit transistor de petit signal ; et
formation d'une électrode de source (57) et d'une électrode de drain (57) pour chacun desdits transistors.
